(19) Europäisches Patentamt
European Patent Office
Office européen des brevets

(11) **EP 2 751 854 B1**

(12) **EUROPÄISCHE PATENTSCHRIFT**

(45) Veröffentlichungstag und Bekanntmachung des Hinweises auf die Patenterteilung:
**25.11.2015 Patentblatt 2015/48**

(21) Anmeldenummer: **12737845.3**

(22) Anmeldetag: **24.07.2012**

(51) Int Cl.:
***H01L 41/273*** *(2013.01)*

(86) Internationale Anmeldenummer:
**PCT/EP2012/064538**

(87) Internationale Veröffentlichungsnummer:
**WO 2013/029884 (07.03.2013 Gazette 2013/10)**

(54) **VERFAHREN ZUR HERSTELLUNG EINES PIEZOELEKTRISCHEN BAUELEMENTS**

METHOD FOR PRODUCING A PIEZOELECTRIC COMPONENT

PROCÉDÉ DE FABRICATION D'UN COMPOSANT PIÉZOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.08.2011 DE 102011112008**

(43) Veröffentlichungstag der Anmeldung:
**09.07.2014 Patentblatt 2014/28**

(73) Patentinhaber: **Epcos AG**
**81669 München (DE)**

(72) Erfinder:
• **GLAZUNOV, Alexander**
**8530 Deutschlandsberg (AT)**
• **FELTZ, Adalbert**
**A-8530 Deutschlandsberg (AT)**

(74) Vertreter: **Epping - Hermann - Fischer**
**Patentanwaltsgesellschaft mbH**
**Schloßschmidstraße 5**
**80639 München (DE)**

(56) Entgegenhaltungen:
EP-A1- 1 959 510          WO-A2-01/45138
DE-A1-102005 061 528     DE-A1-102008 042 965

**Beschreibung**

Es wird ein Verfahren zur Herstellung eines piezoelektrischen Bauelements angegeben.

Piezoelektrische Bauelemente wie piezoelektrische Vielschichtbauelemente, werden zum Beispiel als Aktoren in Kraftstoffeinspritzungen verwendet.

DE 10 2005 061 528 A1, WO 01/45138 A2, EP 1 959 510 A1 und DE 10 2008 042 965 A1 betreffen verschiedene piezoelektrische Vielschichtbauelemente.

Aufgabe zumindest einer Ausführungsform der Erfindung ist die Bereitstellung eines Verfahrens zur Herstellung eines piezoelektrischen Bauelements mit verbesserten Eigenschaften.

Als Referenz wird ein piezoelektrisches Bauelement angegeben, das zumindest eine piezoelektrische Keramikschicht und mindestens eine an die piezoelektrische Keramikschicht angrenzende Elektrode aufweist, wobei die piezoelektrische Keramikschicht ein piezoelektrisches Keramikmaterial der allgemeinen Formel $Pb_{1-x-y-[2a-b)/2]-p/2}V''_{[(2a-b)/2-p/2]}Cu_pBa_xSr_y[(Ti_zZr_{1-z})_{1-a-b}W_aSE_b]O_3$ aufweist. Dabei gilt: $0 \leq x \leq 0,035$, $0 \leq y \leq 0,025$, $0,42 \leq z \leq 0,5$, $0,0045 \leq a \leq 0,009$, $0,009 \leq b \leq 0,011$, $2a > b$, $p \geq 2a-b$, SE ist ein Seltenerdmetall und V'' eine Pb-Leerstelle.

Ein solches Bauelement kann beispielsweise auf beiden Seiten der piezoelektrischen Keramikschicht jeweils eine Elektrode aufweisen. Alternativ kann es sich bei dem Bauelement auch um ein Vielschichtbauelement handeln, das mindestens zwei, bevorzugt mindestens 100 piezoelektrische Keramikschichten enthält. In diesem Fall sind die an die piezoelektrischen Keramikschichten angrenzenden Elektroden Innenelektroden, wobei jeweils eine Innenelektrode zwischen zwei Keramikschichten angeordnet ist. Ein solches Vielschichtbauelement kann weiterhin sich gegenüberliegende Außenflächen aufweisen, auf denen jeweils eine Außenelektrode aufgebracht ist. Die Außenelektroden sind aus dem gleichen Material wie die Innenelektroden hergestellt oder weisen ein unterschiedliches Material als die Innenelektroden auf. Die Innenelektroden sind dann in zwei Gruppen aufgeteilt, wobei eine Gruppe an Innenelektroden mit einer Außenelektrode kontaktiert ist und die andere Gruppe an Innenelektroden mit der anderen Außenelektrode kontaktiert ist.

Bei dem piezoelektrischen Keramikmaterial handelt es sich um eine auf Bleizirkonattitanat (PZT) der allgemeinen Formel $ABO_3$ bzw. $Pb(Zr_{l-z}Ti_z)O_3$ basierende Keramik und weist somit eine Perowskitstruktur auf. PZT-Keramiken weisen eine sogenannte morphotrope Phasengrenze zweier koexistierender ferroelektrischer Phasen, einer tetragonalen und einer rhomboedrischen Phase, auf. Diese PZT-Keramik ist auf ihren B-Plätzen mit W als Donator und einem Seltenerdmetall SE als Akzeptor und, für $x > 0$ und/oder $y > 0$, auf den A-Plätzen mit Ba und/oder Sr dotiert. Die Dotierung mit Ba und/oder Sr kann eine Herabsetzung der Curie-Temperatur des Keramikmaterials bewirken. W kann in der Oxidationsstufe VI vorliegen. Darüber hinaus weist das Keramikmaterial auf A-Plätzen Cu-Kationen auf, die insbesondere in der Oxidationsstufe I vorliegen können. Das Cu wirkt in dem Keramikmaterial während seiner Herstellung als Akzeptor und bewirkt während der Sinterung temporäre Sauerstoffleerstellen, was zu stabilen piezoelektrischen Eigenschaften des piezoelektrischen Bauelements führt. Stabile piezoelektrische Eigenschaften können beispielsweise durch hinreichend dichte piezoelektrische Keramikmaterialien (beispielsweise $\geq 96\%$ der theoretischen Dichte) und einem großen Kornwachstum (mit einer mittleren Korngröße von beispielsweise $\geq 2\ \mu m$ oder $\geq 3\ \mu m$) bewirkt werden.

In Vielschichtbauelementen können vorteilhafte piezoelektrische Eigenschaften von der Mobilität der Verschiebung ferroelektrischer Domänenwände in der PZT-Keramik im elektrischen Feld abhängen. Die Mobilität wird umso weniger eingeschränkt, je geringer die Dichte der Korngrenzen im Volumen der Keramik ist, beziehungsweise je mehr Kornwachstum bis zu einer optimalen mittleren Korngröße im Prozess der Sinterverdichtung zustande kommt. Kornwachstum kann in PZT-Keramiken durch die von Akzeptoren induzierte Bildung von Sauerstoff-Leerstellen gefördert werden.

Weiterhin kann eine kombinierte Donator-Akzeptor-Dotierung auf den B-Plätzen, also eine Dotierung mit W und SE, eine Erhöhung der Konzentration der Leerstellen V'' bewirken, was durch den Einbau von SE-Akzeptorzentren bedingt ist. Gleichzeitig kann während der Sinterung eine entsprechend hohe Sauerstoff-Leerstellenkonzentration $V_o$ herbeigeführt werden. Bei einem solchen Dotierungskonzept kann aufgrund der erhöhten Defektkonzentration bereits bei Temperaturen von etwa 950°C eine hinreichende Sinterverdichtung der piezoelektrischen Keramik erreicht und das für die Ausbildung vorteilhafter piezoelektrischer Eigenschaften wesentliche Kornwachstum beträchtlich vergrößert werden. Das Donator-Akzeptor-Verhältnis kann dabei so eingestellt werden, dass sich in der fertigen Keramik ein geringfügiger Überschuss an Leerstellen auf A-Plätzen ergibt. Die durch SE-Zentren induzierte Sauerstoff-Leerstellenkonzentration während der Sinterung liegt dann in der fertigen Keramik nicht mehr vor. Eine partielle Besetzung der Leerstellen kann durch Cu-Akzeptoren auf den A-Plätzen zustande kommen, was das Kornwachstum zusätzlich fördert.

In PZT-Keramiken können folgende Substitutionen erfolgen: $Pb^{II}$ auf den A-Plätzen kann durch ein höherwertiges Kation substituiert werden, was als positiver Defekt (da jetzt eine positive Ladung mehr auf dem A-Platz lokalisiert ist) bezeichnet wird, wodurch die Bildung eines negativ geladenen Defekts induziert wird (Elektronendonator). Die Neutralisation erfolgt entweder durch Bildung von $Ti^{III}$ auf einem B-Platz oder durch Bildung einer Leerstelle auf einem benachbarten $Pb^{II}$- bzw. A-Platz, beispielsweise V''/2 (Defekttripel). Weiterhin kann $Pb^{II}$ auf den A-Plätzen durch ein niedrigerwertiges Kation substituiert werden, was als negativer Defekt bezeichnet wird, da jetzt eine positive Ladung weniger auf dem A-Platz lokalisiert ist, wodurch die Bildung eines positiv geladenen Defekts induziert wird (Elektronenakzeptor). Die Neutralisation erfolgt durch Bildung einer Leerstelle auf einem Sauerstoffplatz $V_o$" beispielsweise $V_o$"/2 (Defekttripel). $V_o$" kann durch ½ $O_2$ besetzt werden, bildet dann 2 O und somit Defektelektronenzustände im Sauerstoff-Valenzband mit Akzeptorwirkung, was eine schädliche Elektronenleitung blockiert.

$(Ti/Zr)^{IV}$ auf den B-Plätzen kann durch ein höherwertiges Kation substituiert werden, was als Defekt bezeichnet wird, da jetzt eine positive Ladung mehr auf dem B-Platz lokalisiert ist, wodurch die Bildung eines negativ geladenen Defekts induziert wird (Elektronendonator). Die Neutralisation erfolgt entweder durch Bildung von $Ti^{III}$ auf einem B-Platz oder durch Bildung einer Leerstelle auf einem benachbarten $Pb^{II}$- bzw. A-Platz, beispielsweise V"/2 (Defekttripel). Weiterhin kann $(Ti/Zr)^{IV}$ auf den B-Plätzen durch ein niedrigerwertiges Kation substituiert sein, was als Defekt bezeichnet wird, da jetzt eine positive Ladung weniger auf dem B-Platz lokalisiert ist, wodurch die Bildung eines positiv geladenen Defekts induziert wird (Elektronenakzeptor). Die Neutralisation erfolgt durch Bildung einer Leerstelle auf einem Sauerstoffplatz $V_o$", beispielsweise $V_o$"/2 (Defekttripel). $V_o$" kann durch ½ $O_2$ besetzt werden, bildet dann 2 O und somit Defektelektronenzustände im Sauerstoff-Valenzband mit Akzeptorwirkung, was eine schädliche Elektronenleitung blockiert.

Durch kombinierte Donator/Akzeptor-Dotierung kann gleichfalls eine Neutralisation erreicht werden, wobei je nachdem, welcher Anteil überwiegt, Donatoren oder Akzeptoren verbleiben.

Das Seltenerdmetall SE kann aus einer Gruppe ausgewählt sein, die Lu, Yb, Tm, Er, Y, Ho und Dy umfasst. Gemäß einer Ausführungsform ist das Seltenerdmetall Yb. Dieses kann in dem oben genannten piezoelektrischen Keramikmaterial in der Oxidationsstufe III vorliegen.

Die zumindest eine Elektrode kann Cu enthalten oder daraus bestehen. Somit handelt es sich bei dem Bauelement beispielsweise um ein piezoelektrisches Vielschichtbauelement mit Cu-Innenelektroden. Die Verwendung von Cu-Elektroden oder Cu-Innenelektroden ist im Vergleich zu herkömmlichen Elektroden, die beispielsweise aus den Edelmetallen Ag/Pd bestehen, kostengünstiger, was insbesondere bei Vielschichtbauelementen zum Tragen kommt.

Gemäß einer Ausführungsform kann das piezoelektrische Keramikmaterial $Pb_{0,9451}V_{0,00128}$" $CU_{0,003}Ba_{0,0295}Sr_{0,0211}$ $[Ti_{0,467}Zr_{0,516}$ $W_{0,00753}$ $Yb_{0,0095}]O_3$ sein. Dieses Keramikmaterial weist eine hohe Dichte von beispielsweise 97,3% bis 97,5% der theoretischen Dichte auf sowie eine große Korngröße von 2 bis 3 $\mu$m. Die Dielektrizitätskonstante beträgt $\varepsilon = 2100$ und der Kopplungsfaktor $k_p = 0,65$. Damit weist dieses Keramikmaterial vorteilhafte piezoelektrische Eigenschaften auf. Erfindungsgemäß wird ein Verfahren zur Herstellung eines piezoelektrischen Bauelements angegeben. Das Verfahren umfasst die Verfahrensschritte:

A) Herstellung eines kalzinierten, keramischen Vorstufenmaterials der allgemeinen Formel $Pb_{1-x-y-(2a-b)/2}V_{(2a-b)/2}$" $Ba_xSr_y[(Ti_zZr_{1-z})_{1-a-b}W_aSE_b]O_3$,

B) Mischen des kalzinierten, keramischen Vorstufenmaterials mit einem Sinterhilfsmittel,

C) Bilden eines Stapels, der abwechselnd eine Schicht enthaltend die im Verfahrensschritt B) erzeugte Mischung und eine Schicht enthaltend eine Cu aufweist,

D) Entbindern und Sintern des Stapels, wobei ein Bauelement gebildet wird mit Cu-Elektroden und mindestens einer piezoelektrischen Keramikschicht, die ein piezoelektrisches Keramikmaterial der allgemeinen Formel $Pb_{1-x-y-[(2a-b)/2]-p/2}V_{[(2a-b)/2-p/2]}$" $Cu_pBa_xSr_y[(Ti_zZr_{1-z})_{1-a-b}W_aSE_b]O_3$ enthält, wobei für die Indizes in den allgemeinen Formeln gilt $0 \leq x \leq 0,035$, $0 \leq y \leq 0,025$, $0,42 \leq z \leq 0,5$, $0,0045 \leq a \leq 0,009$, $0,009 \leq b \leq 0,011$, $2a > b$, $p \leq 2ab$ und wobei SE ein Seltenerdmetall ist und V" eine Pb-Leerstelle. "Abwechselnd" in Bezug auf den im Verfahrensschritt C) gebildeten Stapel kann auch bedeuten, dass nicht auf jeder Schicht enthaltend die im Verfahrensschritt B) erzeugte Mischung eine Schicht enthaltend Cu aufgebracht wird. Beispielsweise können einige Schichten enthaltend die im Verfahrensschritt B) erzeugte Mischung übereinander angeordnet sein, zwischen denen sich keine Schichten enthaltend Cu befinden. Der gebildete Stapel weist mindestens eine Schicht enthaltend die im Verfahrensschritt B) erzeugte Mischung auf, und zwei auf gegenüber liegenden Seiten der Schicht angeordnete Schichten enthaltend Cu. Unter Stapel ist ebenso eine Anordnung von mehr als zwei, insbesondere mehr als 100 Schichten enthaltend die im Verfahrensschritt B) erzeugte Mischung zu verstehen, zwischen denen Schichten enthaltend Cu angeordnet sind. Ein solcher Stapel wird im Verfahrensschritt D) zu einem Vielschichtbauelement mit Cu-Innenelektroden gebildet.

Mit dem Verfahren kann beispielsweise ein Bauelement gemäß den obigen Ausführungen hergestellt werden. Unter "Schicht" im Verfahrensschritt C) können sowohl Presslinge als auch Folien verstanden werden. Aus Folien kann beispielsweise ein Vielschichtbauelement gebildet werden.

Das Verfahren ermöglicht somit eine Dotierung mit W und einem Seltenerdmetall SE auf den B-Plätzen einer PZT-Keramik mit Perowskitstruktur und zusätzlich den Einbau von Cu-Akzeptorzentren auf den A-Plätzen. Durch die Dotierung auf den B-Plätzen wird bereits eine hohe Effektivität der Ausbildung von Defekten und dadurch die Schwindung, also die Sinterverdichtung, und ein erhöhtes Kornwachstum beim Sintern bewirkt. Durch den zusätzlichen Einbau der Cu-Akzeptorzentren können mit dem Verfahren weiterhin unter Verwendung kostengünstiger Cu-Elektroden Bauelemente mit hoher Performance hergestellt werden.

Gemäß einer Ausführungsform kann der Verfahrensschritt A) die Schritte aufweisen:

A1) Bereitstellen einer Mischung von Ausgangsmaterialien, die aus einer Gruppe ausgewählt sind, die $Pb_3O_4$, $TiO_2$, $ZrO_2$, $WO_3$, $SE_2O_3$, $BaCO_3$ und $SrCO_3$ umfasst,
A2) Kalzinieren der Mischung bei einer ersten Temperatur und Mahlen der Mischung auf einen ersten mittleren Durchmesser,
A3) Kalzinieren der Mischung bei einer zweiten Temperatur, die höher als die erste Temperatur ist.

Damit wird in dem Verfahrensschritt A) also mittels eines Mischoxidverfahrens je nach gewünschter stöchiometrischer Zusammensetzung ein kalziniertes, keramisches Vorstufenmaterial der allgemeinen Formel $Pb_{1-x-y-(2a-b)/2}''V_{(2a-b)/2}'' Ba_x Sr_y [(Ti_z Zr_{1-z})_{1-a-b} W_a SE_b] O_3$ hergestellt, wobei die Indizes aus $0 \leq x \leq 0,035$, $0 \leq y \leq 0,025$, $0,42 \leq z \leq 0,5$, $0,0045 \leq a \leq 0,009$, $0,009 \leq b \leq 0,011$ und $2a > b$ ausgewählt werden. $SE_2O_3$ kann beispielsweise $Yb_2O_3$, $Lu_2O_3$, $Tm_2O_3$, $Er_2O_3$, $Ho_2O_3$, $Dy_2O_3$ oder $Y_2O_3$ sein. Wird der Mischung auch $BaCO_3$ und/oder $SrCO_3$ zugesetzt, kann damit eine Herabsetzung der Curie-Temperatur der Keramik in dem fertigen Bauelement erreicht werden.

In den Verfahrensschritten A2) und A3) können die Oxidkomponenten in zwei Kalzinationsschritten mit Zwischenmahlung umgesetzt werden, was zur Ausbildung eines in Bezug auf die Rezeptur besonders homogenen PZT-Keramikpulvers führt. Die im Verfahrensschritt A1) gemischten Oxidkomponenten können im Verfahrensschritt A2) bei einer ersten Temperatur umgesetzt werden, die aus dem Bereich 850°C bis 925°C ausgewählt ist. Die Umsetzung kann erfolgen, nachdem die Komponenten beispielsweise in einem wässrigen Schlicker mittels $ZrO_2$-Mahlkörpern gemischt, das Wasser abgedampft und die Mischung gesiebt wurde. Die Dauer der Umsetzung kann beispielsweise 2h betragen. Das erhaltene Produkt wird anschließend auf einen ersten mittleren Durchmesser $d_{50}$, der kleiner als 1 $\mu$m gewählt werden kann, gemahlen. Dazu kann das Produkt zunächst in Wasser aufgeschlämmt werden.

Im Verfahrensschritt A3) kann die im Verfahrensschritt A2) erhaltene Mischung ein zweites Mal umgesetzt werden, beispielsweise bei einer zweiten Temperatur, die aus dem Bereich 930°C bis 970°C ausgewählt sein kann. Die Dauer dieser Umsetzung kann beispielsweise 2h betragen. Dazu kann die im Verfahrensschritt A2) erhaltene Mischung zunächst eingedampft und gesiebt werden.

Somit kann bereits im Verfahrensschritt A), in dem eine zweitstufige Kalzination mit Zwischenmahlung durchgeführt wird, ein pulverförmiges keramisches Vorstufenmaterial mit einer weitgehenden Gleichverteilung der Komponenten in der Perowskitstruktur der PZT-Keramik erreicht werden.

Gemäß einer Weiterbildung kann im Verfahrensschritt B) PbO oder $Pb_3O_4$ als Sinterhilfsmittel zugegeben werden. $Pb_3O_4$ kann sich beim Erhitzen bereits ab 500°C unter Sauerstoffabspaltung in PbO umwandeln. Der Anteil des Sinterhilfsmittels kann zwischen 0,5 und 3 mol%, insbesondere zwischen 0,5 und 2 mol% bezogen auf 1 mol keramisches Vorstufenmaterial gewählt werden. Somit kann das eigentliche Sinterhilfsmittel PbO in Form von $Pb_3O_4$ der im Verfahrensschritt A) erhaltenen Mischung zugesetzt werden. Das zugesetzte PbO bildet ab einer Temperatur von etwa 890°C eine Schmelze, wodurch Mechanismen der Flüssigphasensinterung zum Tragen kommen, die das Kornwachstum und die Schwindung kinetisch fördern. Dadurch, dass das Sinterhilfsmittel nicht der Oxidmischung im Verfahrensschritt A) zugefügt wird, sondern erst nach der Synthese der eigenschaftstragenden PZT-Keramikvorstufe zugegeben wird, ist die Zugabe des Sinterhilfsmittels definiert und kontrolliert und somit die Anwendung des Sinterhilfsmittels verbessert. Eine unkontrollierte partielle Eliminierung von PbO infolge Verdampfung und Reaktion mit Brennhilfsmitteln bei der Kalzination können somit vermieden werden. Das Sinterhilfsmittel kann damit entsprechend der gezielt eingesetzten Menge im Prozess der Sinterverdichtung wirksam werden.

Gleichzeitig, vor oder nach der Zugabe des Sinterhilfsmittels kann im Verfahrensschritt B) die im Verfahrensschritt A) erhaltene Mischung auf einen zweiten mittleren Durchmesser, der kleiner als der erste mittlere Durchmesser ist, gemahlen werden. Dabei kann es sich um eine Feinmahlung handeln, die die Sinteraktivität zusätzlich fördern kann. Dazu kann die Mischung, also das Umsatzprodukt des Verfahrensschrittes A) in einer wässrigen Aufschlämmung oder in einem nichtwässrigen Medium wie Ethanol mittels $ZrO_2$-Kugeln, welche einen Durchmesser von $\leq 0,8$ mm aufweisen, gemahlen werden. Der zweite mittlere Durchmesser $d_{50}$, kann aus dem Bereich $< 0,4$ $\mu$m, insbesondere aus dem Bereich 0,3 $\mu$m bis 0,35 $\mu$m, ausgewählt werden. Damit kann eine hohe spezifische Oberflächenenergie erzielt werden und die daraus resultierende Sinteraktivität für die Ausbildung eines optimalen Keramikgefüges bei etwa 1000°C bis 1050°C, insbesondere bei 1000°C bis 1010°C, in Gegenwart von Cu-Elektroden genutzt werden.

Die Kombination aus hoher spezifischer Oberflächenenergie und der Donator-Akzptor-Dotierung auf den B-Plätzen kann die resultierende Triebkraft zur Sinterverdichtung effektiv wirksam machen.

Gemäß einer weiteren Ausführungsform kann im Verfahrensschritt B) zusätzlich $Cu_2O$ mit einem Anteil von 0,05 bis 0,1 mol%, entsprechend dem Anteil p in der allgemeinen Formel zugegeben werden. Damit können Cu-Akzeptorzentren in der PZT-Keramik auf den A-Plätzen erzeugt werden, die bei der Sinterung zusätzlich Sauerstoff-Leerstellen induzieren und dadurch die Sinterverdichtung und das Kornwachstum fördern. Damit können auch die vorteilhaften piezoelektrischen Eigenschaften gefördert werden. Das $Cu_2O$ kann der Mischung zugegeben werden, die bereits auf den zweiten mittleren Durchmesser feingemahlen ist oder einem Schlicker, der aus dem feingemahlenen Pulver hergestellt ist. Das im Verfahrensschritt B) erhaltene feindisperse Pulver kann nach Zusatz eines Binders in ein Granulat überführt werden. Aus dem Granulat können wiederum scheibchenförmige Presslinge oder ein Schlicker zur Herstellung von Keramikfolien bereitet werden. Zur Herstellung eines Schlickers kann ein wässriges oder ein nichtwässriges Dispergiermedium, beispielsweise Butylacetat, in Kombination mit geeigneten Dispergatoren und Bindern angewendet werden. Weiterhin kann im Verfahrensschritt C) die Schicht enthaltend die im Verfahrensschritt B) erzeugte Mischung mit Cu besputtert oder mit einer Cu-Paste bedruckt werden. Ist die Schicht enthaltend die im Verfahrensschritt B) erzeugte Mischung ein Pressling, kann dieser beispielsweise mit Cu besputtert werden. Handelt es sich bei der Schicht um eine Folie, kann diese beispielsweise mit Cu-Paste bedruckt werden.

Gemäß einer Weiterbildung kann im Verfahrensschritt D) die Entbinderung unter Wasserdampf unter Ausschluss von Sauerstoff erfolgen. Dabei kann ab etwa 400°C der aus der thermischen Wasserdampfzersetzung resultierende geringe Sauerstoffpartialdruck noch zusätzlich durch eine gezielte Zuführung von Wasserstoff-Gas (Formiergas) herabgesetzt werden. Die Entbinderung ist der Sinterung vorgelagert, um zunächst die organischen Bestandteile zu eliminieren. Dies kann bei Temperaturen von bis zu 550°C durchgeführt werden. Unter Bildung von $H_2$ und $CO_2$ kann in einem sogenannten Hydroreforming-Prozess der Restkohlenstoffgehalt auf weniger als 300 ppm reduziert werden. Beispielsweise können Binder auf der Basis von Polyurethanen auf Grund ihrer hydrolytischen Spaltung in Monomere für eine Entbinderung durch Wasserdampf bei Ausschluss von Luft besonders geeignet sein. Durch den geringen Restkohlenstoffgehalt nach der Entbinderung wird die Gefahr der Oxidation von Cu bzw. der Reduktion von Pb durch organische Bestandteile vermindert.

Die Sinterung im Verfahrensschritt D) kann bei einem Sauerstoffpartialdruck erfolgen, der zwischen dem Gleichgewichtspartialdruck von PbO/Pb und dem Gleichgewichtspartialdruck von $Cu/Cu_2O$ liegt. Dabei kann der Sauerstoffpartialdruck durch ein Gemisch von Wasserdampf und Formiergas eingestellt werden. Es liegt somit eine Wasserdampf-Wasserstoff-Atmosphäre vor, deren Zusammensetzung für das Prozessfenster zwischen dem Gleichgewichts-Sauerstoffpartialdruck von PbO/Pb und dem von $Cu/Cu_2O$ aus tabellierten thermodynamischen Daten in Abhängigkeit von der Temperatur berechnet werden kann und beispielsweise bei 1000°C zu einem Sauerstoffpartialdruck von etwa $10^{-7}$ führt.. Die Einstellung des Sauerstoffpartialdruckes kann also individuell für die jeweilige Temperatur eingestellt werden. Welcher Sauerstoffpartialdruck bei welcher Temperatur anwendbar ist, kann aus thermodynamischen Daten berechnet und durch eine Sauerstoff-Messsonde kontrolliert werden.

Durch die Anwendung eines Sauerstoffpartialdruckes, der zwischen dem Gleichgewichtspartialdruck von PbO/Pb (bzw. $PbTiO_3$/Pb,$TiO_2$) und dem Gleichgewichtspartialdruck von $Cu/Cu_2O$ liegt, und der temperaturabhängig eingestellt werden kann, kann eine Oxidation von Cu zu $Cu_2O$ und eine Reduktion von PbO zu Pb bzw. von $PbTiO_3$ zu Pb und $TiO_2$ vermieden werden. Gleichzeitig können $W^{VI}$ und $Yb^{III}$ unter derartigen Bedingungen redoxstabil sein, und somit keiner Reduktion unterliegen. Dementsprechend können $W^{VI}$ und $Yb^{III}$ als Defekte in ihrer die Sinterverdichtung und das Kornwachstum fördernden Funktion infolge temporärer Ausbildung von Leerstellen mittelbar voll wirksam werden.

Die Sinterung im Verfahrensschritt D) kann bei einer Temperatur erfolgen, die aus dem Bereich 1000 bis 1050°C, insbesondere aus dem Bereich 1000 bis 1010°C, ausgewählt ist. Dazu kann der Stapel mit einer Heizrate von etwa 3 K/min auf 1000°C bis 1050°C, insbesondere bis 1010°C aufgeheizt werden, und einige Stunden, beispielsweise 3h gehalten werden. Die Abkühlung kann langsamer als das Aufheizen erfolgen.

Durch die Durchführung der Entbinderung und der Sinterung unter den oben erwähnten Prozessbedingungen kann das kalzinierte, mit dem Sinterhilfsmittel versehene keramische Vorstufenmaterial, das zur dotierten PZT-Keramik gesintert wird, geringfügige Mengen an Cu aus den Elektroden, das in der Oxidationsstufe I vorliegt, auf den Leerstellen der A-Plätze aufnehmen. Unter geringfügigen Mengen kann beispielsweise etwa 600 ppm, was 0,003 mol Cu bezogen auf ein mol PZT-Keramik entspricht, verstanden werden. Diese Cu-Akzeptorenzentren induzieren bei der Sintertemperatur zusätzlich Sauerstoff-Leerstellen und fördern dadurch die Sinterverdichtung und das Kornwachstum. Durch die oben genannte, optionale Zugabe von $Cu_2O$ im Verfahrensschritt B) kann dieser Effekt noch verstärkt werden.

Damit kann eine piezoelektrische Keramik hergestellt werden, die $Pb_{1-x-y-[(2a-b)/2]-p/2}V_{[(2a-b)/2-p/2]}''Cu_pBa_xSr_y[(Ti_zZr_{1-z})_{1-a-b}W_aSE_b]O_3$ enthält, wobei gilt: wobei gilt $0 \leq x \leq 0,035$, $0 \leq y \leq 0,025$, $0,42 \leq z \leq 0,5$, $0,0045 \leq a \leq 0,009$, $0,009 \leq b \leq 0,011$, $2a > b$, $p \leq 2a-b$.

Es kann mit dem Verfahren somit ein Bauelement mit verbesserter Performance hergestellt werden. Diese wird durch den Einbau von Cu-Akzeptoren und den definierten Zusatz eines Sinterhilfsmittels für die Sinterverdichtung und Ausbildung eines hinreichend groben Korngefüges mit weniger Korngrenzen im Volumen der Keramik bewirkt. Die aus der spezifischen Oberflächenenergie durch Feinmahlung und die Donator-Akzeptor-Dotierung auf B-Plätzen resultierende Triebkraft zur Sinterverdichtung kann durch Mechanismen der Flüssigphasensinterung kinetisch bedingt effektiv wirksam werden.

Mit dem Verfahren können beispielsweise Stapel von mehreren hundert Keramikschichten mit dazwischen angeordneten Cu-Elektroden gesintert, dadurch verdichtet und in einem nachfolgenden Schritt vereinzelt werden. Somit können beispielsweise Aktoren hergestellt werden.

Gemäß einer Ausführungsform kann in dem Verfahren x = 0,0295, y = 0,0211, z = 0,475, a = 0,00753, b = 0,0095 und SE = Yb gewählt werden so dass im Verfahrensschritt D) mindestens eine piezoelektrische Keramikschicht enthaltend $Pb_{0,9451}V_{0,00128}"Cu_{0,003}Ba_{0,0295}Sr_{0,0211}[Ti_{0,467}Zr_{0,516}W_{0,00753}Yb_{0,0095}]O_3$ hergestellt wird. Dieses Keramikmaterial weist verbesserte piezoelektrische Eigenschaften, wie eine hohe Dichte, hohe Auslenkungsparameter und einen großen mittleren Korndurchmesser auf.

Die Eigenschaften der mit dem Verfahren hergestellten Sinterpresslinge oder Folien können licht- oder elektronenmikroskopisch sowie röntgenographisch bezüglich ihrer Dichte und ihres Gefüges charakterisiert werden. Die dielekterischen und piezoelektrischen Eigenschaften können mittels Auslenkungs- und Resonanzmessungen ermittelt werden.

Im Folgenden werden das angegebene Bauelement und das Verfahren und ihre vorteilhaften Ausgestaltungen anhand von schematischen und nicht maßstabsgetreuen Figuren sowie anhand eines Ausführungsbeispiels erläutert.

Figur 1    zeigt die schematische Seitenansicht eines piezoelektrischen Bauelements (Referenz)

Figur 2    zeigt Partialdrücke von verschiedenen Systemen

Figur 3    zeigt einen Ausschnitt eines Röntgendiffraktogramms

Figur 4    a) bis c) zeigt Abbildungen von Korngefügen von piezoelektrischen Keramiken.

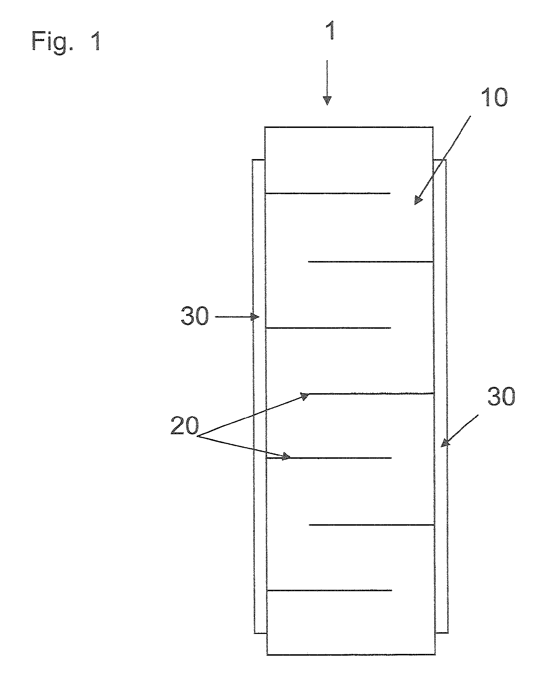

Figur 1 zeigt eine schematische Seitenansicht eines piezoelektrischen Bauelements (Referenz), das als Vielschichtbauelement ausgeführt ist, in Form eines Piezoaktors. Das Bauelement weist einen Stapel 1 aus übereinander angeordneten piezoelektrischen Keramikschichten 10 und dazwischen liegenden Innenelektroden 20 auf. Die Innenelektroden 20 sind als Elektrodenschichten ausgebildet. Die piezoelektrischen Keramikschichten 10 und die Innenelektroden 20 sind übereinander angeordnet.

In der hier gezeigten Ausführungsform sind die Außenelektroden 30 auf gegenüberliegenden Seitenflächen des Stapels 1 angeordnet und verlaufen streifenförmig entlang der Stapelrichtung. Die Außenelektroden 30 enthalten beispielsweise Ag oder Cu und können als Metallpaste auf den Stapel 1 aufgebracht und eingebrannt werden.

Die Innenelektroden 20 sind entlang der Stapelrichtung abwechselnd bis zu einer der Außenelektroden 30 geführt und von der zweiten Außenelektrode 30 beabstandet. Auf diese Weise sind die Außenelektroden 30 entlang der Stapelrichtung abwechselnd mit den Innenelektroden 20 elektrisch verbunden. Zur Herstellung des elektrischen Anschlusses kann auf die Außenelektroden 30 ein Anschlusselement (hier nicht gezeigt), z. B. durch Löten, aufgebracht werden.

Bei den Innenelektroden 20 handelt es sich um Cu-Innenelektroden. Die piezoelektrischen Keramikschichten enthalten als Material $Pb_{1-x-y[(2a-b)/2]-p/2}V_{[(2a-b)/2-p/2]}"Cu_pBa_xSr_y[(Ti_zZr_{1-z})_{1-a-b}W_aSE_b]O_3$ wobei gilt: $0 \leq x \leq 0,035$, $0 \leq y \leq 0,025$, $0,42 \leq z \leq 0,5$, $0,0045 \leq a \leq 0,009$, $0,009 \leq b \leq 0,011$, $2a > b$, $p \leq 2a-b$, SE ist ein Seltenerdmetall und V" eine Pb-Leerstelle. Beispielsweise enthalten die piezoelektrischen Keramikschichten das Material $Pb_{0,9451}V_{0,00128}"Cu_{0,003}Ba_{0,0295}Sr_{0,0211}[Ti_{0,467}Zr_{0,516}W_{0,00753}Yb_{0,0095}]O_3$.

Anhand des folgenden Ausführungsbeispiels soll die Herstellung des Bauelements enthaltend das Material $Pb_{0,9451}V_{0,00128}"Cu_{0,003}Ba_{0,0295}Sr_{0,0211}[Ti_{0,467}Zr_{0,516}W_{0,00753}Yb_{0,0095}]O_3$ erläutert werden:

Gemäß der allgemeinen Formel $Pb_{1-x-y-(2a-b)/2}V_{(2a-b)/2}"Ba_xSr_y[(Ti_zZr_{1-z})_{1-a-b}W_aSE_b]O_3$, werden die Parameter x = 0,0295, y = 0,0211, z = 0,475, a = 0,00753, b = 0,0095 und SE = Yb ausgewählt, woraus sich $Pb_{0,9466}V_{0,00278}"Ba_{0,0295}Sr_{0,0211}[Ti_{0,467}Zr_{0,516}W_{0,00753}Yb_{0,0095}]O_3$ ergibt.

Zunächst werden die Rohstoffe $Pb_3O_4$, $TiO_2$, $ZrO_2$, $WO_3$, $Yb_2O_3$, $BaCO_3$ und $SrCO_3$, deren Verunreinigungsgehalt kontrolliert und deren Metallgehalt jeweils gesondert bestimmt wurde, im entsprechenden Molverhältnis eingewogen und mit $ZrO_2$-Mahlkörpern 24h in einem wässrigen Schlicker rotierend gemischt (Verfahrensschritt A1). Nach dem Eindampfen und Sieben wird bei 925°C mit einer Haltezeit von 2 Stunden in einer $ZrO_2$-Kapsel umgesetzt und das Reaktionsprodukt unter Zusatz von Wasser einer Mahlung mit $ZrO_2$-Kugeln (Durchmesser 2 mm) in einer Excentermühle unterworfen (Verfahrensschritt A2). Bei 300 cycl/min wird bereits nach 30 Minuten ein erster mittlerer Durchmesser $d_{50}$ von 0,66 $\mu m$ (entsprechend $d_{90}$ = 1,64 $\mu m$) erhalten. Der Schlicker wird eingedampft, durch ein Sieb gerieben und bei 2h Haltezeit bei 950°C ein zweites Mal umgesetzt, um die Reaktion zu vervollständigen (Verfahrensschritt A3).

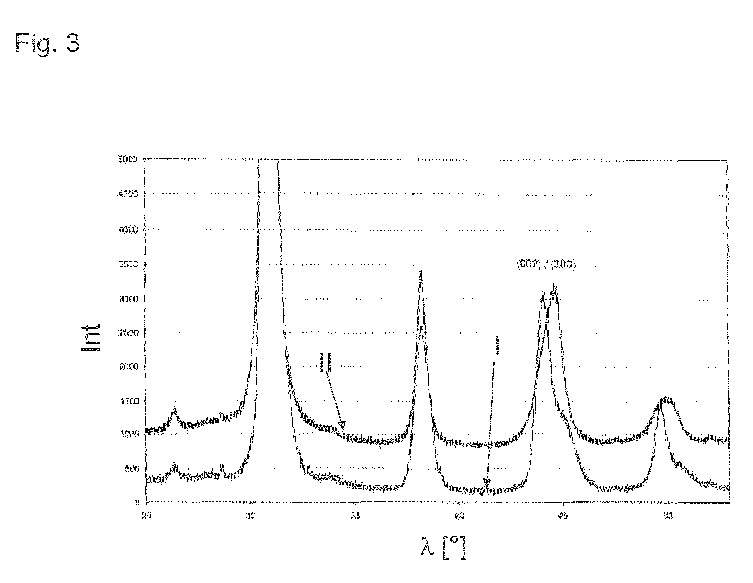

Figur 3 zeigt als Ausschnitt eines Röntgendiffraktogramms, bei dem der Winkel $\lambda$ in ° gegen die Intensität Int aufgetragen ist, den Vergleich zwischen dem ersten und zweiten Kalzinationsschritt, also der Produkte nach dem Verfahrensschritt A2) und nach dem Verfahrensschritt A3). Nach dem ersten Umsatz (Kurve I) liegen noch Ti-reichere tetragonale Partikel neben Zr-reicheren rhomboedrischen Kristalliten vor, was an einer Aufspaltung des 200/002-Reflexes erkennbar ist. Nach dem zweiten Umsatz (Kurve II) ist die Aufspaltung nicht mehr auflösbar, worin die bessere Gleichverteilung von Ti und Zr im Gitter der PZT-Perowskitstruktur erkennbar ist.

Das bei 950°C erhaltene Umsatzpulver wird nach dem Zusatz von 2,5 mol% PbO in Form von $Pb_3O_4$ in einer Excentermühle in Wasser oder Ethanol mit $ZrO_2$-Kugel (Durchmesser 0,8 mm) einer Feinmahlung auf 0,3 bis 0,35 $\mu$m unterzogen (Verfahrensschritt B). Dazu sind bei 300 cycl/min etwa 2h erforderlich. Das Dispergiermedium wird abgedampft, gesiebt und nach Zugabe eines PEG-Binders (Polyethylenglykol) ein Granulat angefertigt, aus dem Scheibchen von 15,5 mm Durchmesser und einer Dicke von 1,4 bis 1,5 mm gepresst werden.

Diese Grünkörper werden vor der Sinterung durch Sputtern mit Cu-Elektroden versehen (Verfahrensschritt C).

Die scheibchenförmigen Presslinge werden zunächst durch Aufheizen an der Luft bis auf 500°C entbindert und anschließend mit einer Aufheizrampe von 6K/min bei 1000°C und einer Haltezeit von 3h gesintert (Verfahrensschritt D, Vergleichsprobe 1). Weitere Presslinge werden bei gleicher Entbinderung und Aufheizrampe bei 950°C mit 4h Haltezeit gesintert (Vergleichsprobe 2). Weitere Presslinge werden in einer Atmosphäre mit vermindertem Sauerstoffpartialdruck, der bereits beim Aufheizen mit 3K/min durch das Verhältnis von Wasserdampf zu Formiergas temperaturabhängig eingestellt wird, bei 1010°C mit 4h Haltezeit gesintert (Ausführungsbeispiel).

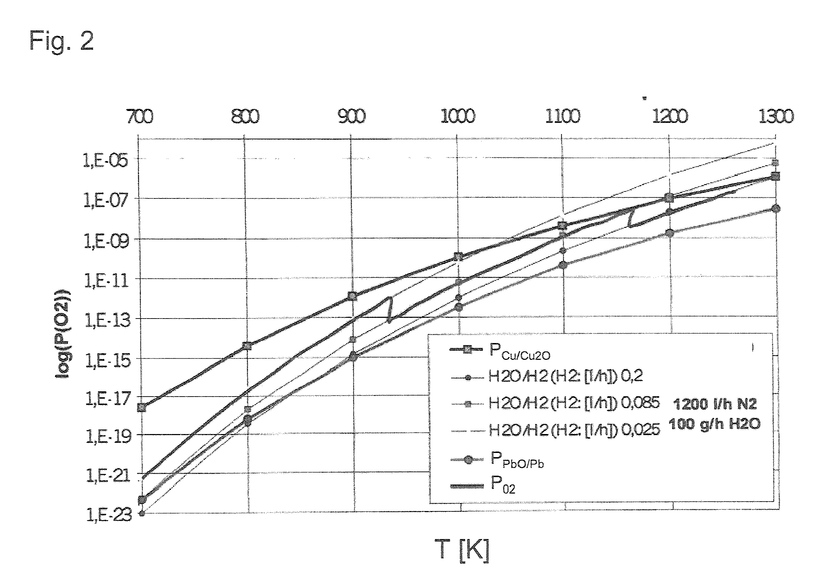

Figur 2 zeigt dazu verschiedene Partialdrücke, nach denen der geeignete Sauerstoffpartialdruck temperaturabhängig ausgewählt werden kann. In dem Graphen sind die Temperatur T in K gegen den logarithmischen Sauerstoffpartialdruck log (p(O2)) aufgetragen. Gezeigt sind der Gleichgewichtspartialdruck des Systems $Cu/Cu_2O$ $P_{Cu/Cu2O}$ und des Systems PbO/Pb $P_{PbO/Pb}$. Zwischen diesen Gleichgewichtspartialdrücken darf der Sauerstoffpartialdruck $P_{O2}$ variieren, wenn eine Oxidation von Cu zu $Cu_2O$ und eine Reduktion von PbO zu Pb (bzw. von $PbTiO_3$ zu Pb und $TiO_2$) vermieden werden soll. In Figur 2 ist ein möglicher Verlauf des Sauerstoffpartialdrucks, der während des gesamten Sintervorgangs zwischen den Gleichgewichtspartialdrucken $P_{Cu/Cu2O}$ und $P_{PbO/Pb}$ liegt, gezeigt. Dieser weist bei 940K und bei 1170 K Sprünge auf. Die Sprünge liegen zwischen drei, in der Figur 2 ebenfalls gezeigten Linien, welche unterschiedlichen Mengen an Formiergas entsprechen (Linie mit kleinen Punkten, Linie mit kleinen Quadraten, Linie mit Lücken). Wenn die Mengen an $N_2$ und des $H_2O$-Dampfs konstant bleiben, kann man durch die Einstellung der Formiergasmenge den Sauerstoffpartialdruck während der Sinterung einstellen.

Bei der Sinterung tritt, auch unter den definierten Prozessbedingungen des Ausführungsbeispiels, eine Kontamination von Cu aus den Elektroden im Bereich von etwa 600 ppm auf. Die Cu-Kationen der Oxidationsstufe I werden als Cu-Akzeptoren unter Eliminierung einer äquivalenten Menge von 0,0015 mol PbO eingebaut, so das sich für die Endzusammensetzung einer unter diesen Bedingungen hergestellten Piezokeramik die folgende Formel ergibt: $Pb_{0,9451}V_{0,00128}" CU_{0,003}Ba_{0,0295}Sr_{0,0211} [Ti_{0,467}Zr_{0,516} W_{0,00753}Yb_{0,0095}]O_3$.

Die Sinterdichte wird an den scheibchenförmigen Proben durch Wägung und Ermittlung der geometrischen Abmessungen an jeweils fünf Einzelproben bestimmt und die relative Dichte $\rho_{rel}$ durch Vergleich mit der Röntgendichte der PZT-Perowskitphase mit $\rho_{th}$ = 8,03 $g/cm^3$ berechnet. Bei den mit 2,5 mol% PbO als Sinterhilfsmittel versehenen Proben wird nach dem Sintern bei 1000°C eine Dichte $\rho$ = 7,83 $\pm$ 0,04 $g/cm^3$ entsprechend 97,5% der theoretischen Dichte gefunden, und selbst bei einer Sinterung bei 950°C wird ein vergleichbarer Wert $\rho$ = 8,81 $\pm$ 0,04 $g/cm^3$ entsprechend 97,3% der theoretischen Dichte erreicht. Die unter definierten Prozessbedingungen erhaltene Sinterdichte liegt bei 7,7 bis 7,9 $g/cm^3$. Bei Verzicht auf den Zusatz von PbO in Form von $Pb_3O_4$ wird nach dem Sintern bei 1000°C für die relative Dichte nur ein Wert $\rho_{rel}$ = 84,9% festgestellt.

Die durch Feinmahlung eingebrachte freie spezifische Oberflächenenergie und die durch Donator-Akzeptor-Dotierung auf den B-Plätzen induzierte Bildung sinterfördernder Defekte reichen demnach nicht aus, um bereits bei 1000°C eine hohe Sinterverdichtung zu ermöglichen. Die Zugabe von 2,5 mol% PbO in Form von $Pb_3O_4$ als Sinterhilfsmittel erweist sich als notwendig, um eine hinreichend dichte Piezokeramik zu erhalten.

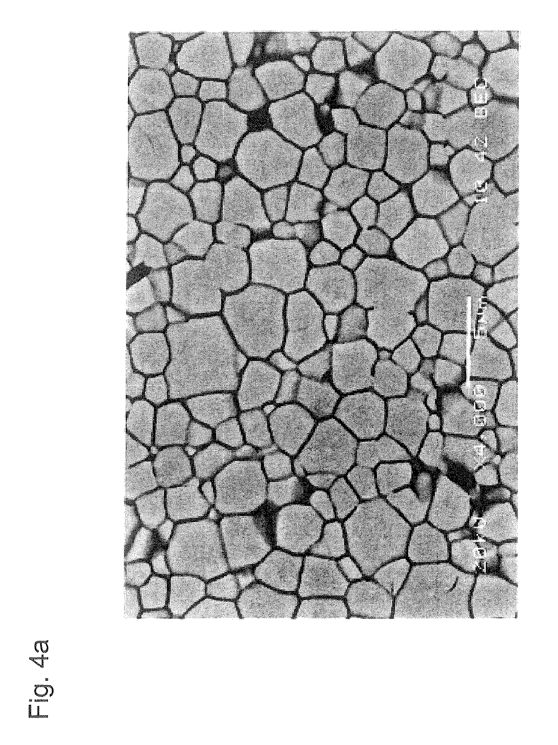

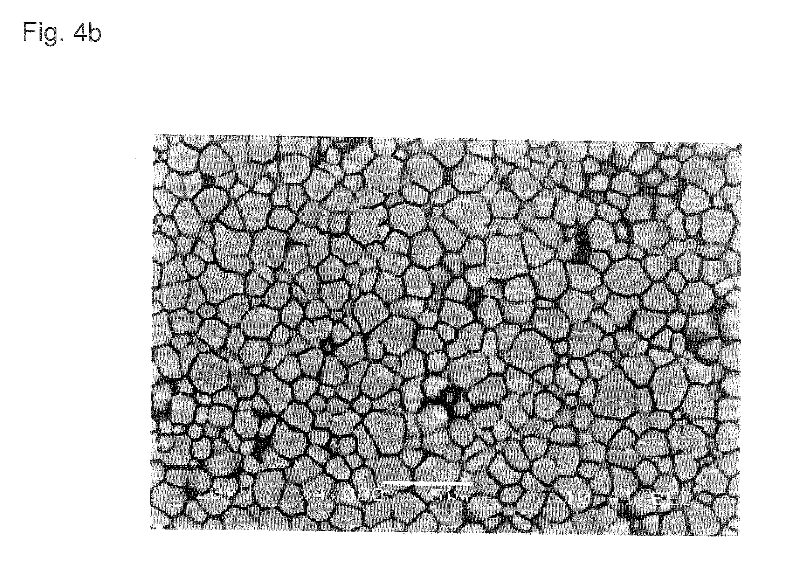

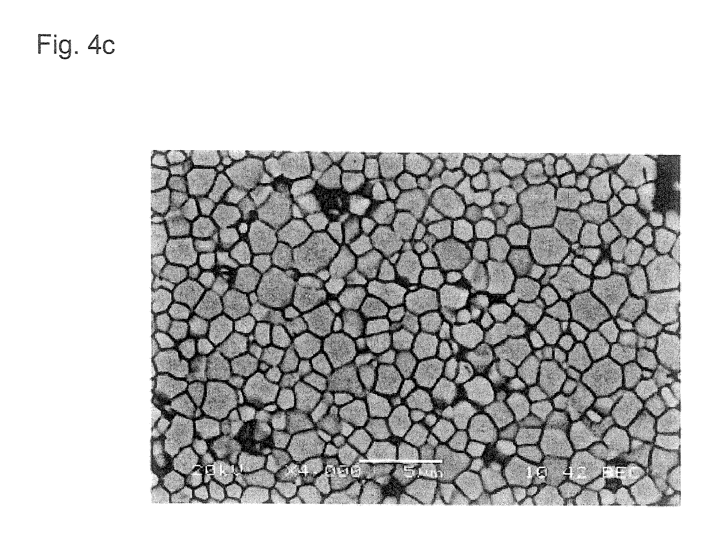

Figur 4 zeigt Abbildungen von Korngefügen von piezoelektrischen Keramiken. In Figur 4 a) ist das beim Sintern bei 1010°C erhaltene Gefüge gezeigt, wenn der Sauerstoffpartialdruck temperaturabhängig während der Haltezeit von 4h dem in Figur 2 gezeigten Verlauf entspricht. Die Wirkung der durch den zusätzlichen Einbau der Cu-Akzeptorzentren auf das Kornwachstum ist deutlich zu erkennen. Der durchschnittliche Korndurchmesser beträgt 2 bis 3 $\mu$m. Dagegen zeigen die in den Figuren 4 b) und 4 c) gezeigten Korngefüge der Vergleichsproben 1 und 2 (Sinterung an Luft bei 1000°C für 3h bzw. Sinterung an Luft bei 950°C für 4 h) kleinere durchschnittliche Korndurchmesser von 1 bis 2,5 $\mu$m (Figur 4b) und 0,5 bis 2 $\mu$m (Figur 4c).

Weitere charakteristische Größen des mit Cu-Elektroden versehenen Presslings gemäß dem Ausführungsbeispiels sind im Folgenden angegeben: Der Auslenkungsparameter $d_{33}$, der der piezoelektrischen Ladungskonstante entspricht, kann durch die Beziehung $S_3 = d_{33}*E_3$ mit der relativen Dehnung S = $\Delta$l/l und der elektrischen Feldstärke E definiert werden. Die nach der Polung mit ca. 3 kV/mm ausgeführte Messung ergibt $d_{33}$ = 520 pm/V. Aus einer Kapazitätsmessung ergibt sich für die Dielektrikzitätskonstante der Wert $\varepsilon$ = 2100. Für den planaren Kopplungsfaktor wurde gemäß der Beziehung

$$k_p \cong \left[ 2{,}51 \frac{f_a - f_r}{f_r} - \left( \frac{f_a - f_r}{f_a} \right)^2 \right]^{\frac{1}{2}}$$

der Wert $k_p = 0{,}65$ ermittelt.

Bezugszeichenliste

| 1 | Stapel |
|---|---|
| 10 | piezoelektrische Keramikschicht |
| 20 | Innenelektrode |
| 30 | Außenelektroden |
| Int | Intensität |
| λ | Winkel |
| I | Röntgendiffraktogramm nach erstem Kalzinationsschritt |
| II | Röntgendiffraktogramm nach zweitem Kalzinationsschritt |
| T | Temperatur |
| P(OP2) | Sauerstoffpartialdruck |
| $P_{Cu/Cu2O}$ | Gleichgewichtspartialdruck von $C_u/Cu_2O$ |
| $P_{PbO/Pb}$ | Gleichgewichtspartialdruck von PbO/Pb |

**Patentansprüche**

1. Verfahren zur Herstellung eines piezoelektrischen Bauelements mit den Verfahrensschritten

   A) Herstellung eines kalzinierten, keramischen Vorstufenmaterials der allgemeinen Formel (I) $Pb_{1-x-y-(2a-b)/2}V_{(2a-b)/2}''Ba_xSr_y[(Ti_zZr_{1-z})_{1-a-b}W_aSE_b]O_3$,
   B) Mischen des kalzinierten, keramischen Vorstufenmaterials mit einem Sinterhilfsmittel,
   C) Bilden eines Stapels (1), der abwechselnd eine Schicht enthaltend die im Verfahrensschritt B) erzeugte Mischung und eine Schicht enthaltend Cu aufweist,
   D) Entbindern und Sintern des Stapels (1), wobei ein Bauelement gebildet wird mit Cu-Elektroden (20) und mindestens einer piezoelektrischen Keramikschicht (10), die ein piezoelektrisches Keramikmaterial der allgemeinen Formel (II) $Pb_{1-x-y-[(2a-b)/2]-p/2}V_{[(2a-b)/2-p/2]}''Cu_pBa_xSr_y[(Ti_zZr_{1-z})_{1-a-b}W_aSE_b]O_3$ enthält,
   wobei für die Indizes in den allgemeinen Formeln (I) und (II) gilt $0 \leq x \leq 0{,}035$, $0 \leq y \leq 0{,}025$, $0{,}42 \leq z \leq 0{,}5$, $0{,}0045 \leq a \leq 0{,}009$, $0{,}009 \leq b \leq 0{,}011$, $2a > b$, $p \leq 2a-b$ und wobei SE ein Seltenerdmetall ist und V'' eine Pb-Leerstelle.

2. Verfahren nach dem vorhergehenden Anspruch, wobei der Verfahrensschritt A) die Schritte

   A1) Bereitstellen einer Mischung von Ausgangsmaterialien, die aus einer Gruppe ausgewählt sind, die $Pb_3O_4$, $TiO_2$, $ZrO_2$, $WO_3$, $SE_2O_3$, $BaCO_3$ und $SrCO_3$ umfasst,
   A2) Kalzinieren der Mischung bei einer ersten Temperatur und Mahlen der Mischung auf einen ersten mittleren Durchmesser,
   A3) Kalzinieren der Mischung bei einer zweiten Temperatur, die höher als die erste Temperatur ist, umfasst.

3. Verfahren nach einem der vorhergehenden Ansprüche 1 oder 2, wobei im Verfahrensschritt B) PbO oder $Pb_3O_4$ als Sinterhilfsmittel zugegeben wird, und der Anteil des Sinterhilfsmittels zwischen 0,5 und 3 mol% bezogen auf 1 mol keramisches Vorstufenmaterial gewählt wird.

4. Verfahren nach einem der vorhergehenden Ansprüche 1 bis 3, wobei im Verfahrensschritt B) die im Verfahrensschritt A) erhaltene Mischung auf einen zweiten mittleren Durchmesser, der kleiner als der erste mittlere Durchmesser ist, gemahlen wird.

5. Verfahren nach einem der Ansprüche 3 oder 4, wobei im Verfahrensschritt B) zusätzlich $Cu_2O$ mit einem Anteil von 0,05 bis 0,1 mol% zugegeben wird.

6. Verfahren nach einem der Ansprüche 1 bis 5, wobei im Verfahrensschritt C) die Schicht enthaltend die im Verfahrensschritt B) erzeugte Mischung mit Cu besputtert oder mit einer Cu-Paste bedruckt wird.

7. Verfahren nach einem der Ansprüche 1 bis 6, wobei im Verfahrensschritt D) die Entbinderung unter Wasserdampf unter Ausschluss von Sauerstoff erfolgt.

8. Verfahren nach einem der Ansprüche 1 bis 7, wobei im Verfahrensschritt D) die Sinterung bei einem Sauerstoffpartialdruck erfolgt, der zwischen dem Gleichgewichtspartialdruck von PbO/Pb und dem Gleichgewichtspartialdruck von $Cu/Cu_2O$ liegt.

9. Verfahren nach dem vorhergehenden Anspruch, wobei der Sauerstoffpartialdruck durch ein Gemisch von Wasserdampf und Formiergas eingestellt wird.

10. Verfahren nach einem der Ansprüche 1 bis 9, wobei die Sinterung im Verfahrensschritt D) bei einer Temperatur erfolgt, die aus dem Bereich 1000 bis 1050°C ausgewählt ist.

11. Verfahren nach einem der Ansprüche 1 bis 10, wobei x = 0,0295, y = 0,0211, z = 0,475, a = 0,00753, b = 0,0095 und Yb für SE ausgewählt werden und im Verfahrensschritt D) eine piezoelektrische Keramikschicht (10) enthaltend $Pb_{0,9451}V_{0,00128}'' Cu_{0,003}Ba_{0,0295}Sr_{0,0211} [Ti_{0,467}Zr_{0,516}W_{0,00753} Yb_{0,0095}]O_3$ hergestellt wird.

## Claims

1. Method for producing a piezoelectric component, with the method steps of

    A) producing a calcined, ceramic precursor material of the general formula (I)

    $$Pb_{1-x-y(2a-b)/2}V_{(2a-b)/2}'' Ba_xSr_y[(Ti_zZr_{1-z})_{1-a-b}W_aRE_b]O_3,$$

    B) mixing the calcined, ceramic precursor material with a sintering aid,
    C) forming a stack (1) which has in alternation a layer comprising the mixture produced in method step B) and a layer comprising Cu,
    D) debindering and sintering the stack (1), with formation of a component having Cu electrodes (20) and at least one piezoelectric ceramic layer (10) which comprises a piezoelectric ceramic material of the general formula (II) $Pb_{1-x-y-[(2a-b)/2]-p/2}V_{[(2a-b)/2-p/2]}'' Cu_pBa_xSr_y[(Ti_zZr_{1-z})_{1-a-b}W_aRE_b]O_3$, for the indices in the general formulae (I) and (II), where, $0 \leq x \leq 0.035$, $0 \leq y \leq 0.025$, $0.42 \leq z \leq 0.5$, $0.0045 \leq a \leq 0.009$, $0.009 \leq b \leq 0.011$, $2a > b$, $p \leq 2a-b$ and where RE is a rare earth metal, and V'' is a Pb vacancy.

2. Method according to the preceding claim, where method step A) comprises the steps of

    A1) providing a mixture of starting materials which are selected from a group which encompasses $Pb_3O_4$, $TiO_2$, $ZrO_2$, $WO_3$, $SE_2O_3$, $BaCO_3$ and $SrCO_3$,
    A2) calcining the mixture at a first temperature and milling the mixture to a first average diameter,
    A3) calcining the mixture at a second temperature which is higher than the first temperature.

3. Method according to either of preceding Claims 1 and 2, where in method step B) PbO or $Pb_3O_4$ is added as sintering aid, and the fraction selected for the sintering aid is between 0.5 and 3 mol%, based on 1 mol of ceramic precursor material.

4. Method according to any of preceding Claims 1 to 3, where in method step B) the mixture obtained in method step A) is milled to a second average diameter which is smaller than the first average diameter.

5. Method according to either of Claims 3 and 4, where in method step B) additionally $Cu_2O$ is added with a fraction of 0.05 to 0.1 mol%.

6. Method according to any of Claims 1 to 5, where in method step C) the layer comprising the mixture produced in method step B) is sputter-coated with Cu or printed with a Cu paste.

7. Method according to any of Claims 1 to 6, where in method step D) the debindering takes place under steam with exclusion of oxygen.

8. Method according to any of Claims 1 to 7, where in method step D) the sintering takes place at an oxygen partial pressure which lies between the equilibrium partial pressure of PbO/Pb and the equilibrium partial pressure of $Cu/Cu_2O$.

9. Method according to the preceding claim, where the oxygen partial pressure is set by a mixture of steam and forming gas.

10. Method according to any of Claims 1 to 9, where the sintering in method step D) takes place at a temperature selected from the 1000 to 1050°C range.

11. Method according to any of Claims 1 to 10, where x = 0.0295, y = 0.0211, z = 0.475, a = 0.00753, b = 0.0095, and Yb for RE are selected and in method step D) a piezoelectric ceramic layer (10) comprising $Pb_{0.9451}V_{0.00128}'' Cu_{0.003}Ba_{0.0295}Sr_{0.0211} [Ti_{0.467}Zr_{0.516}W_{0.00753} Yb_{0.0095}]O_3$ is produced.

## Revendications

1. Procédé de fabrication d'un composant piézoélectrique, comprenant les étapes de procédé suivantes :

   A) la fabrication d'un matériau précurseur céramique calciné de formule générale (I)

   $$Pb_{1-x-y-(2a-b)/2}V_{(2a-b)/2}'' Ba_xSr_y[(Ti_zZr_{1-z})_{1-a-b}W_aSE_b]O_3,$$

   B) le mélange du matériau précurseur céramique calciné avec un adjuvant de frittage,
   C) la formation d'une pile (1) qui comprend en alternance une couche contenant le mélange formé à l'étape de procédé B) et une couche contenant Cu,
   D) le déliage et le frittage de la pile (1), un composant étant formé, qui comprend des électrodes en Cu (20) et au moins une couche céramique piézoélectrique (10), qui contient un matériau céramique piézoélectrique de formule générale (II)

   $$Pb_{1-x-y-[(2a-b)/2]-p/2}V_{[(2a-b)/2-p/2]}'' Cu_pBa_xSr_y[(Ti_zZr_{1-z})_{1-a-b}W_aSE_b]O_3$$

   les indices dans les formules générales (I) et (II) étant tels que $0 \le x \le 0,035$, $0 \le y \le 0,025$, $0,42 \le z \le 0,5$, $0,0045 \le a \le 0,009$, $0,009 \le b \le 0,011$, $2a > b$, $p \le 2a-b$, et SE étant un métal de terres rares et V'' étant une lacune de Pb.

2. Procédé selon la revendication précédente, dans lequel l'étape de procédé A) comprend les étapes suivantes :

   A1) la préparation d'un mélange de matériaux de départ choisis dans un groupe comprenant $Pb_3O_4$, $TiO_2$, $ZrO_2$, $WO_3$, $SE_2O_3$, $BaCO_3$ et $SrCO_3$,
   A2) la calcination du mélange à une première température et le broyage du mélange à un premier diamètre moyen,
   A3) la calcination du mélange à une seconde température, qui est supérieure à la première température.

3. Procédé selon l'une quelconque des revendications 1 ou 2 précédentes, dans lequel, à l'étape de procédé B), PbO ou $Pb_3O_4$ est ajouté en tant qu'adjuvant de frittage, et la proportion d'adjuvant de frittage est choisie entre 0,5 et 3 % en moles, par rapport à 1 mole de matériau précurseur céramique.

4. Procédé selon l'une quelconque des revendications 1 à 3 précédentes, dans lequel, à l'étape de procédé B), le mélange obtenu à l'étape de procédé A) est broyé à un second diamètre moyen, qui est inférieur au premier diamètre moyen.

**5.** Procédé selon l'une quelconque des revendications 3 ou 4, dans lequel, à l'étape de procédé B), du $Cu_2O$ est en outre ajouté en une proportion de 0,05 à 0,1 % en moles.

**6.** Procédé selon l'une quelconque des revendications 1 à 5, dans lequel, à l'étape de procédé C), la couche contenant le mélange formé à l'étape de procédé B) est pulvérisée avec Cu ou imprimée avec une pâte de Cu.

**7.** Procédé selon l'une quelconque des revendications 1 à 6, dans lequel, à l'étape de procédé D), le déliage a lieu sous vapeur d'eau avec exclusion de l'oxygène.

**8.** Procédé selon l'une quelconque des revendications 1 à 7, dans lequel, à l'étape de procédé D), le frittage a lieu à une pression partielle d'oxygène comprise entre la pression partielle à l'équilibre de PbO/Pb et la pression partielle à l'équilibre de $Cu/Cu_2O$.

**9.** Procédé selon la revendication précédente, dans lequel la pression partielle d'oxygène est ajustée par un mélange de vapeur d'eau et d'un mélange hydrogène-azote.

**10.** Procédé selon l'une quelconque des revendications 1 à 9, dans lequel le frittage à l'étape de procédé D) a lieu à une température choisie dans la plage allant de 1 000 à 1 050 °C.

**11.** Procédé selon l'une quelconque des revendications 1 à 10, dans lequel x = 0,0295, y = 0,0211, z = 0,475, a = 0,00753, b = 0,0095 et SE = Yb et, à l'étape de procédé D), une couche céramique piézoélectrique (10) contenant $Pb_{0,9451}V_{0,00128}'' Cu_{0,003}Ba_{0,0295}Sr_{0,0211} [Ti_{0,467}Zr_{0,516}W_{0,00753}Yb_{0,0095}] O_3$ est fabriquée.

Fig. 1

Fig. 2

Fig. 3

Fig. 4a

Fig. 4b

Fig. 4c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005061528 A1
- WO 0145138 A2
- EP 1959510 A1
- DE 102008042965 A1